Europäisches Patentamt

European Patent Office

Office européen des brevets

(19)

(11) **EP 0 529 580 B1**

(12) **FASCICULE DE BREVET EUROPEEN**

(45) Date de publication et mention
de la délivrance du brevet:
**11.12.1996 Bulletin 1996/50**

(51) Int Cl.6: **H01S 3/103**, H01S 3/096,
H01S 3/25, G02F 2/02,
H04Q 3/52

(21) Numéro de dépôt: **92114461.4**

(22) Date de dépôt: **25.08.1992**

(54) **Procédé et dispositif de commande d'un convertisseur de longueur d'onde optique**

Optischer Wellenlängenwandler und Verfahren zu seinem Betrieb

Optical wavelength converter and method of operation of the same

(84) Etats contractants désignés:
**AT BE CH DE ES FR GB IT LI NL SE**

(30) Priorité: **30.08.1991 FR 9110789**

(43) Date de publication de la demande:
**03.03.1993 Bulletin 1993/09**

(73) Titulaire: **ALCATEL CIT**
**F-75008 Paris (FR)**

(72) Inventeurs:
• **Gabriagues, Jean-Michel**
**F-91530 Le Val Saint-Germain (FR)**
• **Jacquinot, Jean-Claude**
**F-94270 Le Kremlin-Bicetre (FR)**
• **Le Roy, Guy**
**F-22300 Lannion (FR)**
• **Jacob, Jean-Baptiste**
**F-22700 Perros-Guirec (FR)**

(74) Mandataire: **Weinmiller, Jürgen et al**
**Lennéstrasse 9**
**Postfach 24**
**82336 Feldafing (DE)**

(56) Documents cités:
**EP-A- 0 396 371**

• **IEEE JOURNAL OF QUANTUM ELECTRONICS.
vol. 24, no. 11, Novembre 1988, New
York,US;pages 2153 - 2159,H. KAWAGUCHI et
al.:'Tunable optical wavelength conversion
using an optically triggerable multielectrode
distributed feedback laser diode'**
• **OPTICAL FIBER COMMUNICATION
CONFERENCE,vol. PD10, no. 1, Janvier 1988,
New Orleans, US;pages 251 - 254 S. YAMAKOSHI
et al.:'An optical wavelength conversion laser
with tunable range of 30 A.'**
• **PATENT ABSTRACTS OF JAPAN,vol. 7, no. 166
(E-188)21 Juillet 1983;& JP-A-58073174**

**Description**

La présente invention concerne la conversion de longueur d'onde de signaux optiques.

On sait que la longueur d'onde de signaux optiques est avantageusement utilisée, notamment dans des systèmes de commutation ou de transmission optiques, par exemple à des fins de multiplexage, pour permettre de distinguer les uns des autres différents signaux optiques acheminés sur un support de transmission commun, ou encore à des fins de routage ou de commutation spatiale, pour affecter à des signaux optiques un chemin de propagation déterminé parmi un ensemble de chemins de propagation possibles. Il se pose alors fréquemment dans de tels systèmes le problème de "changer" de longueur d'onde, étant entendu que cette longueur d'onde est celle d'une porteuse optique modulée par les données à transmettre par ces systèmes.

Une façon de procéder pour réaliser un tel changement de longueur d'onde consiste à détecter lesdites données par un photo-récepteur, puis à utiliser le signal électrique issu de ce transducteur pour moduler une source optique, le cas échéant accordable, émettant à la longueur d'onde souhaitée.

Une autre façon de procéder, permettant l'économie d'une conversion optique-électrique puis d'une conversion électrique-optique, a depuis peu été rendue possible grâce à un composant opto-électronique convertisseur de longueur d'onde, constitué par un laser semi-conducteur particulier, dit à absorbant saturable, déclenchable optiquement et accordable électriquement.

Un tel composant est décrit par exemple dans le document : Optical Fibre Communication Conference - New Orleans - 25, 28 janvier 1988 : "An optical - wavelength conversion laser with tunable range of 30 A" S. Yamakoshi, K. Kondo, M. Kuno.

Brièvement, il comporte un guide de lumière formé d'une juxtaposition de plusieurs sections, dont l'une, dans laquelle est injecté le signal optique incident, est réalisée dans un matériau dit absorbant saturable, et qui sont respectivement munies d'électrodes de commande pour l'application de divers signaux électriques de commande, qui sont respectivement en l'occurrence un signal de commande d'absorbant saturable, un signal de commande de gain, et un signal de commande de longueur d'onde du signal optique émis par ce laser.

Le couple formé par le signal de commande de gain, (par exemple un courant, noté $I_1$) et par le signal de commande d'absorbant saturable (par exemple un courant, noté $I_2$) forme un point de fonctionnement de ce laser pour lequel celui-ci peut être déclenché optiquement, suivant le niveau de puissance lumineuse incidente. Par ailleurs, lorsque ce laser est effectivement déclenché, la longueur d'onde du signal optique qu'il émet est déterminée par le signal de commande de longueur d'onde.

La présente invention a pour but la commande d'un composant convertisseur de longueur d'onde optique du type ainsi rappelé, permettant notamment d'élaborer automatiquement les signaux de commande à appliquer aux électrodes de commande d'un tel composant pour obtenir, pour un composant donné, la longueur d'onde d'émission souhaitée.

Suivant l'application envisagée pour un tel convertisseur de longueur d'onde, ladite longueur d'onde d'émission souhaitée peut, ou non, être obtenue à partir de données spécifiques contenues dans le signal optique incident appliqué à ce convertisseur ; une application où elle peut ainsi être obtenue à partir de telles données spécifiques correspond à l'application à une matrice de commutation photonique permettant de commuter des données sous la forme de cellules de longueur fixe, multiplexées par un multiplexage temporel asynchrone, auquel cas lesdites données spécifiques se trouvent dans l'en-tête de ces cellules. On rappelle en effet que ces cellules ont un format fixe, comportant un champ de données dites utiles, précédé d'un en-tête comportant des données dites auxiliaires.

L'invention est particulièrement utilisable dans cette application à une matrice de commutation photonique.

La présente invention a pour objet un procédé de commande d'un convertisseur de longueur d'onde optique, en fonction de la longueur d'onde d'émission souhaitée, ledit convertisseur de longueur d'onde présentant une entrée de signal optique pour la réception d'un signal optique dont la longueur d'onde est à convertir, une sortie de signal optique, pour l'émission d'un signal optique dont la longueur d'onde est la longueur d'onde souhaitée, après conversion, et au moins une électrode de commande pour l'application d'au moins un signal électrique en vue de la commande de longueur d'onde du signal optique d'émission, caractérisé en ce qu'il comporte :

- une phase dite d'étalonnage comportant elle-même :

  . l'établissement d'une loi liant l'un au moins desdits signaux électriques de commande à ladite longueur d'onde d'émission souhaitée,
  . la mémorisation de ladite loi dans des moyens de mémorisation,

- une phase dite opératoire comportant elle-même :

  . un adressage desdits moyens de mémorisation par : des informations (C) de commande représentant la longueur d'onde d'émission souhaitée,
  . une conversion numérique-analogique des données issues des moyens de mémorisation ainsi adressés, pour application à ladite électrode de commande, ou auxdites électrodes de commande.

La présente invention a également pour objet un dispositif de mise en oeuvre de ce procédé de commande.

D'autres objets et caractéristiques de la présente invention apparaîtront à la lecture de la description suivante d'exemples de réalisation, faite en relation avec les dessins ci-annexés dans lesquels :

- la figure 1 est un schéma synoptique d'un dispositif de commande suivant un premier exemple de réalisation de l'invention,
- la figure 2 est un schéma synoptique d'un dispositif de commande suivant un deuxième exemple de réalisation de l'invention,
- la figure 3 est un schéma synoptique d'un dispositif de commande suivant un troisième exemple de réalisation de l'invention,
- la figure 4 est un schéma synoptique illustrant l'application de l'invention à une matrice de commutation photonique,
- les figures 5, 6, 7 représentent un schéma détaillé d'un dispositif de commande suivant l'invention, à titre d'exemple suivant ledit troisième exemple de réalisation,
- la figure 8 est un chronogramme relatif audit troisième exemple de réalisation de l'invention, à titre d'exemple dans le cadre de son application à une matrice de commutation photonique telle qu'illustrée par le schéma de la figure 4,
- la figure 9 est un schéma synoptique d'un montage possible pour la mise en oeuvre de la phase dite d'étalonnage du procédé de commande suivant l'invention.

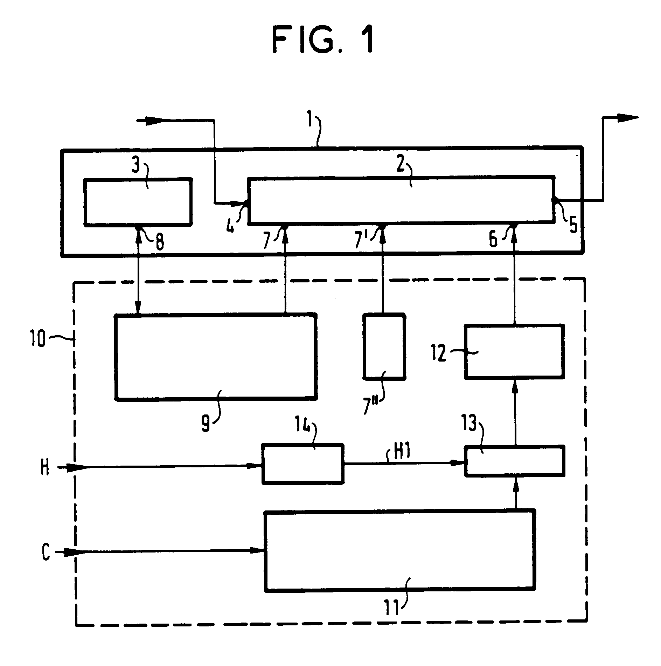

Sur la figure 1 est représenté un ensemble 1 appelé module convertisseur de longueur d'onde optique, comportant un composant convertisseur de longueur d'onde, 2, constitué en l'occurrence par un laser semi-conducteur à absorbant saturable, associé de façon classique à un organe 3 appelé régulateur thermique, ces deux éléments étant localisés dans une même enceinte.

Le convertisseur de longueur d'onde 2 présente une entrée de réception de signal optique, 4, une sortie d'émission de signal optique, 5, et une ou plusieurs électrodes de commande électrique, qui sont en l'occurrence une électrode 6 de commande de longueur d'onde, une électrode 7 de commande de gain, et une électrode 7' de commande d'absorbant saturable.

Le régulateur thermique 3 a par ailleurs des accès de commande, 8. Il comporte, de façon classique, un capteur de température et un régulateur thermique proprement dit, et ses accès 8 communiquent de façon classique avec un circuit de commande de régulation thermique 9.

Ce circuit 9 de commande de régulation thermique fait partie d'un dispositif 10 de commande du module convertisseur de longueur d'onde 1 et est en l'occurrence un circuit de commande de régulation thermique et de commande de gain, puisque le gain (que l'on considère ici devoir être maintenu constant) est, suivant cet exemple de réalisation, considéré comme indépendant de la longueur d'onde d'émission, fonction seulement de la température.

Le dispositif de commande 10 comporte, outre le circuit 9 de commande de régulation thermique et de commande de gain :

- des moyens de mémorisation 11, en l'occurrence une mémoire du type RAM, qui est adressée par des informations de commande C représentant la longueur d'onde souhaitée pour le signal optique d'émission, et pouvant, suivant l'application, être obtenues ou non à partir de données spécifiques contenues dans le signal optique incident,
- des moyens 12 de conversion numérique-analogique, pour convertir en un signal analogique (par exemple un courant) à appliquer à l'électrode de commande de longueur d'onde 6, les données obtenues en sortie de la mémoire RAM 11 ainsi adressée par les informations de commande C,
- un registre-tampon 13 pour la prise en compte des données de sortie de la mémoire RAM 11, à un instant, déterminé par une base de temps 14, fonction de l'instant souhaité pour l'application d'un signal de commande à l'électrode de commande de longueur d'onde 6, cet instant étant lui-même fonction du type d'application envisagé pour ce dispositif et étant, dans le cas où la longueur d'onde d'émission souhaitée est obtenue à partir de données spécifiques contenues dans le signal optique incident, déterminé à partir d'un signal d'horloge définissant le rythme des données de modulation de la porteuse optique incidente. Un tel signal d'horloge, noté H sur la figure 1, est appliqué à la base de temps 14, le signal d'horloge délivré par la base de temps 14 étant noté H1.

Sur la figure 1, l'électrode 7' de commande d'absorbant saturable est en outre reliée à la sortie d'une source de signal électrique 7" qui délivre par exemple un courant dont la valeur sera précisée ultérieurement, lors de la description de la phase dite d'étalonnage du procédé de commande suivant l'invention.

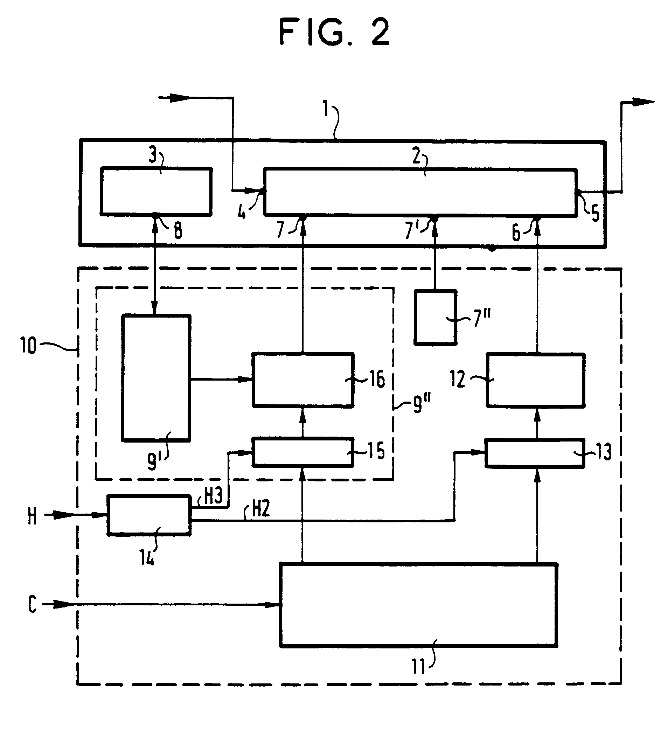

Le dispositif de commande 10 représenté sur la figure 2 diffère essentiellement de celui représenté sur la figure 1 en ce que le signal de commande appliqué à l'électrode de commande de gain 7 est obtenu de façon similaire à celui appliqué à l'électrode de commande de longueur d'onde 6, le gain étant, suivant cet exemple de réalisation, considéré comme fonction de la température et de la longueur d'onde.

La mémoire RAM 11 comporte alors, pour chaque adresse, deux types de données, d'une part des données relatives au gain et d'autre part des données relatives à la longueur d'onde, les données relatives au gain étant de façon similaire appliquées à l'électrode de commande 7, par l'intermédiaire d'un registre-tampon 15 et d'un convertisseur numérique-analogique 16.

Sur la figure 2 sont repérés H2 et H3 les signaux d'horloge délivrés par la base de temps 14 et commandant respectivement les registres-tampons 13 et 15, de façon analogue au signal H1 de la figure 1.

Le moyen repéré 16 est cependant en l'occurrence plus complexe qu'un simple convertisseur numérique-analogique, et comporte en outre des moyens de régulation du gain en fonction de la température, comme réalisé dans le bloc 9 de la figure 1, auquel cas une liaison est à prévoir entre ce moyen 16 et un circuit, repéré alors 9', de commande de régulation de température. L'ensemble formé par ce circuit 9' et par les blocs 15 et 16 forme alors un circuit de commande de régulation thermique et de commande de gain, repéré 9''.

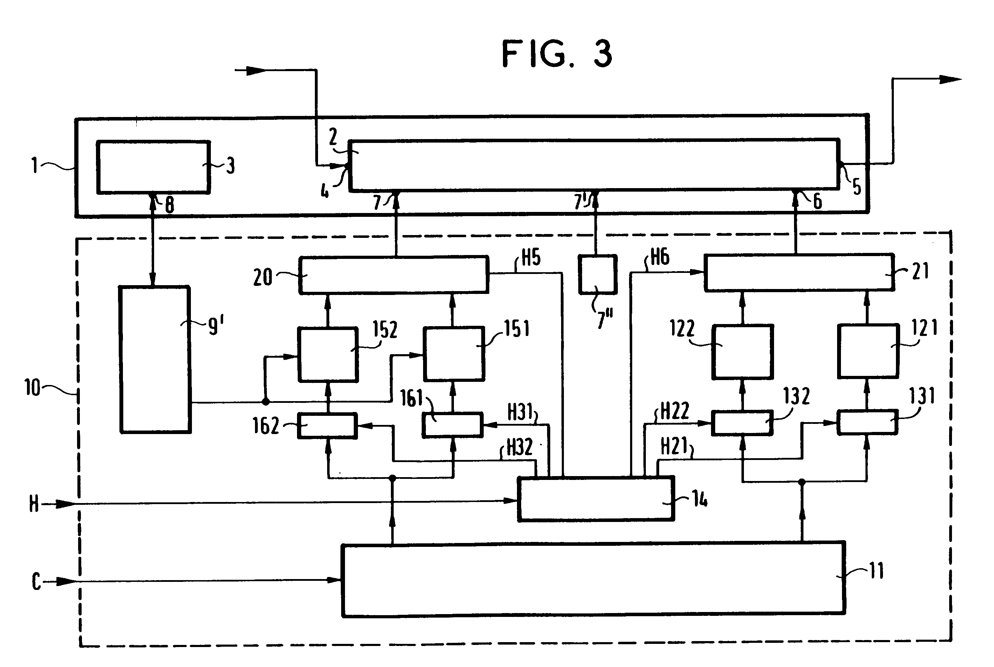

Le dispositif de commande 10 représenté sur la figure 3 diffère de celui représenté sur la figure 2 en ce que chaque chaîne de commande, de longueur d'onde d'une part et de gain d'autre part, est doublée, ceci notamment pour des applications telles que celle déjà mentionnée relative à une matrice de commutation photonique, où l'élaboration, par une telle chaîne de commande, du signal de commande correspondant à appliquer l'électrode de commande correspondante de ce composant nécessite un temps de traitement incompatible avec le rythme de changement de longueur d'onde imposé sur le signal optique incident.

Sur la figure 3 sont respectivement notés 151 et 161 d'une part, 152 et 162 d'autre part, le convertisseur numérique-analogique et le registre-tampon de chacune des deux chaînes de commande relatives à la commande de gain, et 121 et 131 d'une part, 122 et 132 d'autre part, le convertisseur numérique-analogique et le registre-tampon de chacune des deux chaînes de commande relatives à la commande de longueur d'onde.

Sur la figure 3 sont en outre repérés $H_{21}$ et $H_{22}$ d'une part, $H_{31}$ et $H_{32}$ d'autre part les signaux d'horloge délivrés par la base de temps 14 et commandant respectivement d'une part les registres-tampons 131 et 132, d'autre part les registres-tampons 161 et 162.

Un commutateur de sélection d'une chaîne de commande parmi deux, respectivement 20, 21, est alors nécessaire, ce commutateur recevant un signal d'horloge de commande, respectivement $H_5$, $H_6$, de la base de temps 14.

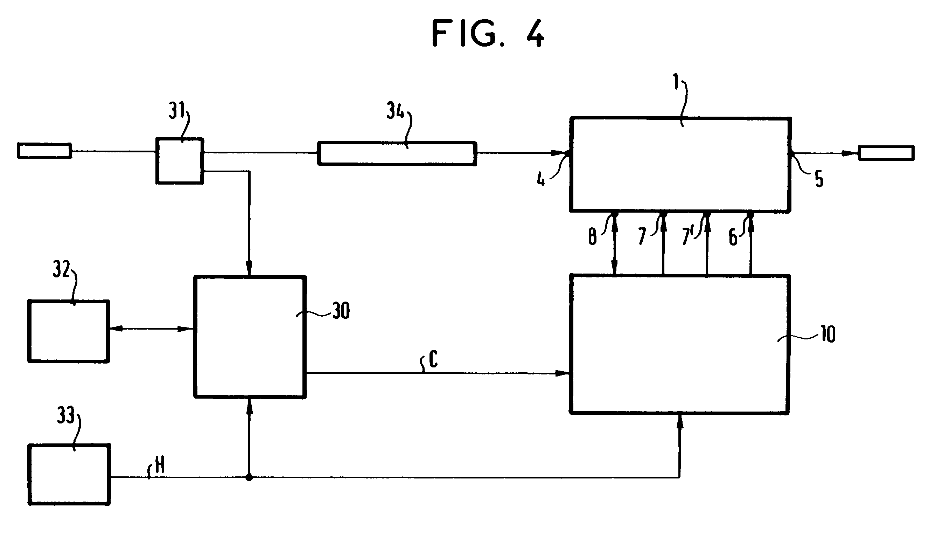

La figure 4 illustre l'application d'un dispositif suivant l'un quelconque des exemples de réalisation précédents à une matrice de commutation photonique utilisant une conversion de la longueur d'onde utilisée pour la transmission de données incidentes se présentant sous la forme de cellules multiplexées par un multiplexage temporel asynchrone.

Dans ce cas, et comme indiqué plus haut, la longueur d'onde sur laquelle doit être transposée chacune de ces cellules est déduite de données spécifiques contenues dans l'en-tête de cette cellule. C'est pourquoi les informations de commande C sont alors fournies par un organe de commande 30 qui reçoit une fraction du signal optique incident (prélevée par un coupleur 31), qui détecte les en-têtes de ces cellules et qui extrait de ces en-têtes lesdites données spécifiques, suivant des principes classiques et non redécrits ici, cet organe 30 fonctionnant pour cela, et également de façon classique, sous la commande d'un processeur central de traitement 32 du système de commutation incluant cette matrice, et d'une base de temps générale 33 de ce système de commutation.

Pour faire coïncider l'instant d'application, sur les électrodes de commande du convertisseur de longueur d'onde, des signaux de commande fournis par le dispositif de commande 10 à partir des informations de commande C ainsi élaborées par cet organe de commande 30, avec l'instant d'application, sur l'entrée optique de ce convertisseur, de la cellule à partir de laquelle cet organe de commande 30 a délivré ces informations de commande C, une ligne à retard optique 34 est prévue sur le trajet des signaux optiques entre le coupleur 31 et le module convertisseur de longueur d'onde 1.

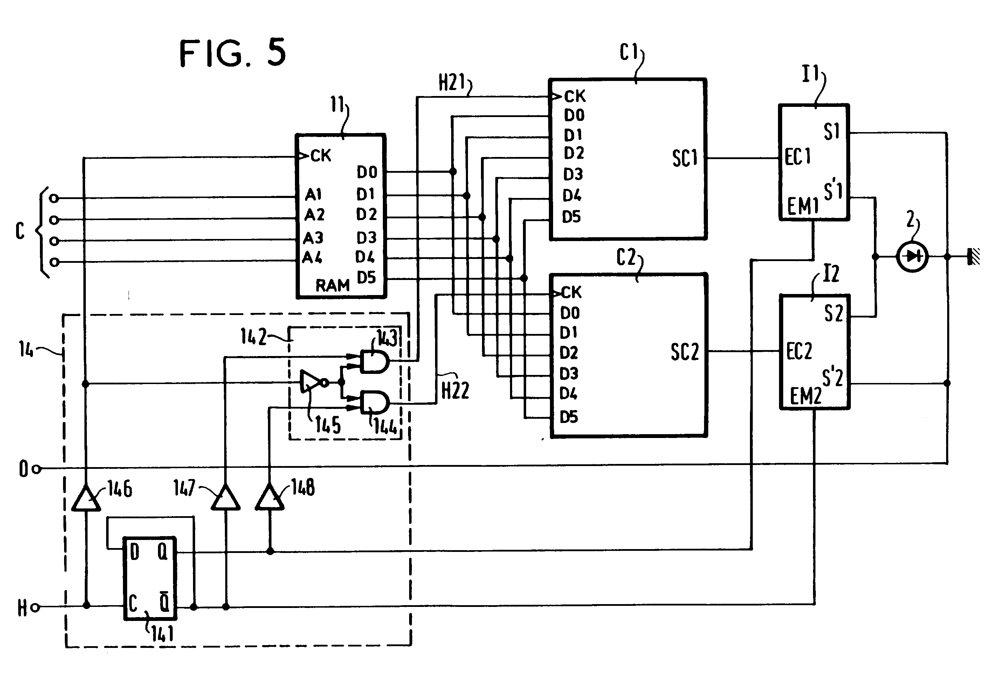

On décrit maintenant, en relation avec les figures 5, 6 et 7 un schéma de réalisation d'un dispositif de commande d'un convertisseur de longueur d'onde, suivant les principes exposés dans les schémas précédents, en considérant à titre d'exemple celui de la figure 3, et pour simplifier en ne représentant que l'une des deux chaînes de commandes, à titre d'exemple relatives à la commande de longueur d'onde, l'autre de ces chaînes pouvant être réalisée de façon analogue.

On reconnaît sur la figure 5 la mémoire RAM 11 qui reçoit sur ses entrées d'adresse les informations numériques de commande C. Les données issues de cette mémoire ainsi adressée sont aiguillées vers les entrées de données de deux circuits C1 et C2, dont l'entrée d'horloge CK reçoit respectivement l'un des signaux $H_{21}$, $H_{22}$ délivrés par la base de temps 14, permettant d'activer alternativement ces deux registres, au rythme des changements de longueur d'onde imposés sur le signal optique incident, ce rythme étant indiqué par le signal d'horloge H appliqué à cette base de temps 14.

Cette base de temps 14 comporte en l'occurrence d'une part un diviseur de fréquence par deux, constitué de façon classique par une bascule du type D, référencée 141, dont la sortie inverseuse notée $\overline{Q}$ est rebouclée sur l'entrée D, l'entrée d'horloge de cette bascule D recevant en l'occurrence le signal d'horloge H, et d'autre part un séquenceur 142 comportant deux portes ET 143, 144 et un inverseur 145.

Chacune des portes ET 143, 144 reçoit d'une part le signal de sortie de l'inverseur 145, lequel reçoit le signal d'horloge H, et d'autre part respectivement les signaux disponibles sur les sorties inverseuse, $\overline{Q}$, et non inverseuse, Q, de la bascule D 141.

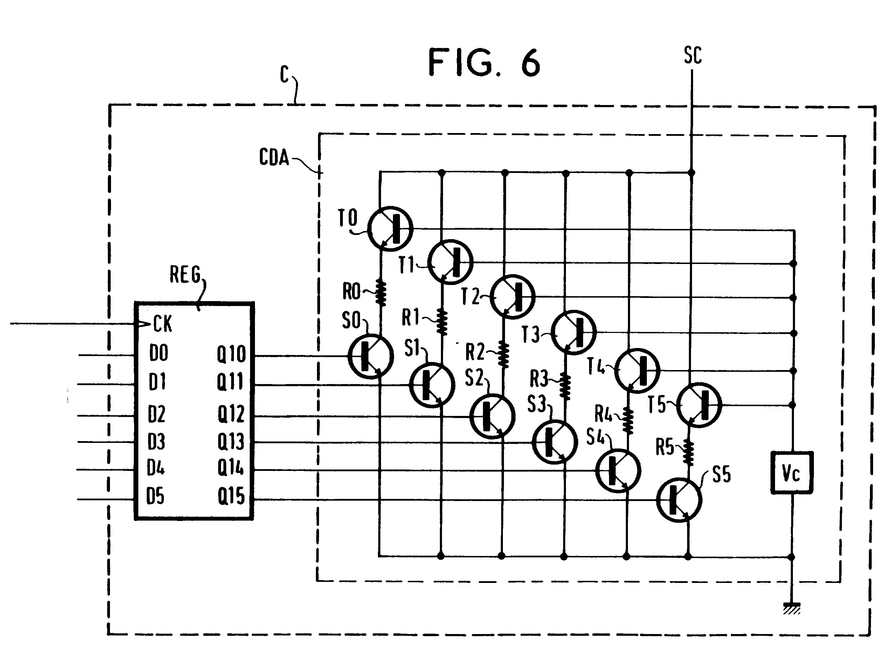

La structure des circuits C1 et C2 est détaillée dans la figure 6 : chaque circuit, noté C, regroupe un registre noté REG (131, 132) et un convertisseur numérique-analogique noté CDA (121, 122), dont un exemple de réalisation est également donné.

Suivant cet exemple, chaque convertisseur numérique-analogique CDA comporte un transistor multi-émetteurs à "m" émetteurs, où "m" désigne le nombre de bits des mots binaires mémorisés dans la mémoire 11, avec à titre d'exemple "m" égal à 6, ces "m" émetteurs étant repérés respectivement $T_0$, $T_1$...$T_5$ et étant associés respectivement à l'une de "m" résistances $R_0$ à $R_5$ (dont les valeurs correspondent respectivement aux poids binaires des différents bits des mots binaires mémorisés dans la mémoire 11) et à l'un de "m" transistors, notés $S_0$, $S_1$...$S_5$, ces transistors $S_0$, $S_1$...$S_5$ étant eux-mêmes commandés respectivement par les "m" sorties de la mémoire RAM, via le registre REG associé. L'alimentation du transistor multi-émetteurs est réalisée par une source de tension $V_c$.

Le courant de collecteur de ce transistor multi-émetteurs est la somme des courants des "m" émetteurs de ce transistor. Ce courant, ainsi commandé à partir d'informations numériques, à travers les résistances $R_0$, $R_1$...$R_5$, et les transistors $S_0$...$S_5$ fonctionnant en interrupteurs, est le courant physique qui va alimenter l'entrée de commande de longueur d'onde du convertisseur de longueur d'onde.

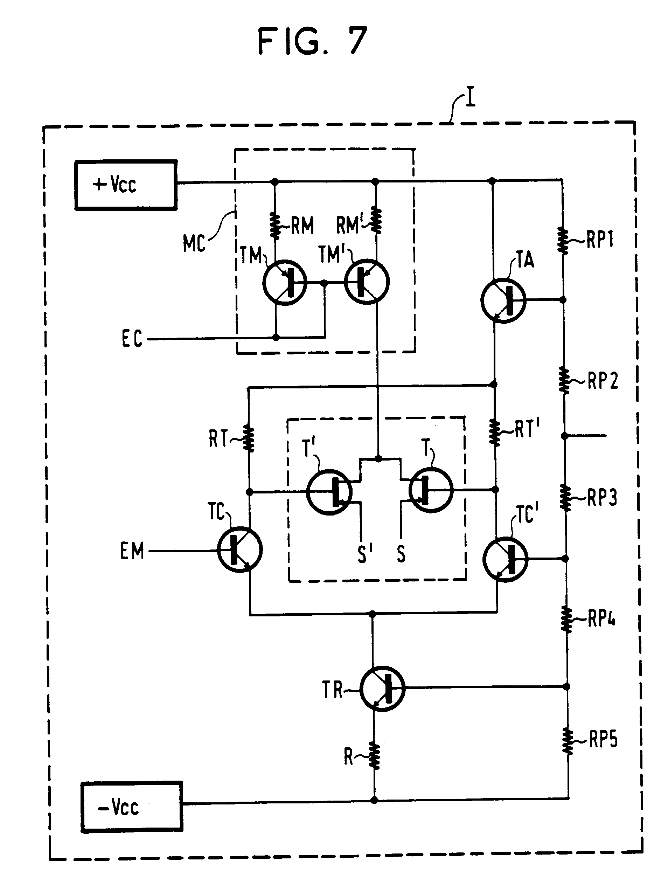

Cette alimentation s'effectue dans cet exemple par l'intermédiaire d'un commutateur, en l'occurrence par l'intermédiaire du commutateur 21, comportant lui-même deux interrupteurs, $I_1$, $I_2$, dont un exemple de réalisation est donné dans la figure 7.

Suivant cet exemple chaque interrupteur, noté I, comporte une entrée de courant EC, connectée à la sortie SC du convertisseur numérique-analogique CDA associé, une entrée dite de marquage EM connectée à une sortie du diviseur par deux 141, et deux sources de tension notées $+V_{cc}$ (polarité positive) et $-V_{cc}$ (polarité négative).

La structure de l'interrupteur I dans cet exemple de réalisation est imposée par des contraintes physiques sur la polarité des signaux électriques mis en jeu ; on a en effet trois classes distinctes de circuits élémentaires constituant le circuit de commande représenté sur la figure 5.

- Les circuits fonctionnant avec des temps de basculement très court (de l'ordre du temps bit), sont classiquement réalisés en technologie ECL, dont on sait que la polarité des niveaux logiques est négative.

- Les circuits fonctionnant à cadence faible, sont avantageusement réalisables avec une technologie compatible avec les niveaux TTL, par exemple CMOS.

- Enfin, pour des raisons physiques, le convertisseur de longueur d'onde, commandable en courant, doit être alimenté par des signaux électriques de polarité positive ; en d'autres termes, c'est un dispositif à cathode commune selon l'état de l'art actuel.

Pour ces raisons, l'interrupteur I a pour fonction de commander la longueur d'onde d'émission du convertisseur de longueur d'onde, à partir d'un signal de marquage de polarité négative. Un mode de réalisation possible est ainsi donné dans la figure 7 : l'alimentation du convertisseur de longueur d'onde proprement dit est fournie par une paire différentielle de transistors à effet de champ, T, T' dont les drains sont raccordés et alimentés en courant par la sortie d'un circuit MC (miroir de courant) et dont les sources constituent les sorties S, S' de l'interrupteur I. Le circuit miroir de courant MC est lui-même connecté à l'entrée de courant EC et comporte de façon classique deux transistors, notés TM, TM' et deux résistances RM, RM'.

La commande de la paire T, T' est elle-même réalisée via une paire différentielle de transistors NPN, TC, TC' associés à deux résistances RT, RT', la base de l'un des ces transistors recevant les signaux ECL de marquage à l'entrée EM, et les émetteurs de ces transistors étant reliés à un transistor TR monté en générateur de courant et associé à une résistance R. Un ensemble de résistances RP1 à RP5 et un transistor d'alimentation TA fournissent les valeurs des tensions de polarisation permettant le fonctionnement du montage.

Le raccordement des sorties S1, S'1 et S2, S'2 des interrupteurs $I_1$ et $I_2$ avec le laser 2, de même que le raccordement des entrées de marquage EM1 et EM2 au diviseur 141, permettent un fonctionnement en alternat.

Enfin, dans l'exemple choisi, l'adaptation des niveaux ECL des circuits rapides avec les niveaux TTL des circuits lents est réalisée par l'intermédiaire de translateurs de niveaux, 146, 147 et 148, selon une technique connue.

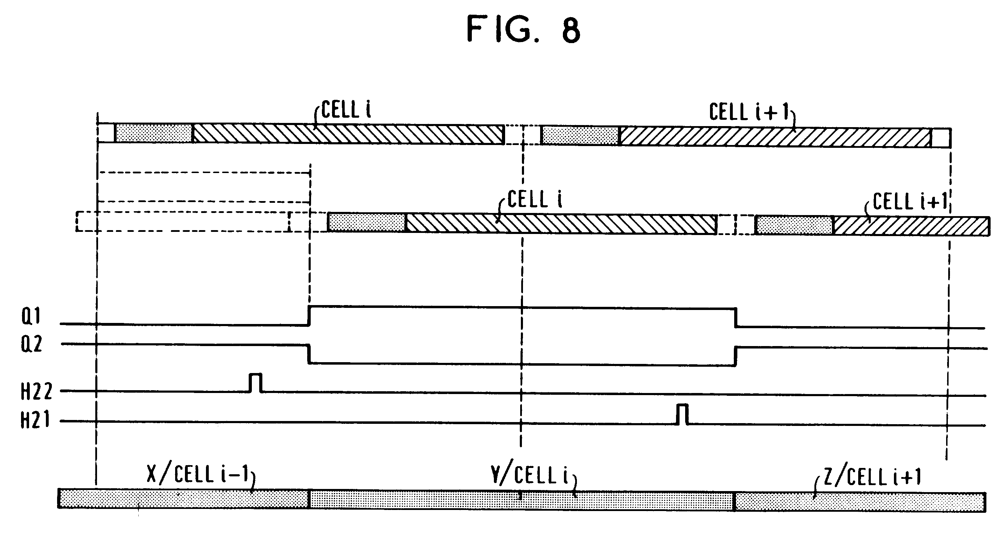

On décrit maintenant, en relation avec la figure 8, le chronogramme illustrant le fonctionnement du dispositif tel que celui de la figure 3 par exemple, à titre d'exemple dans le cadre de l'application de ce dispositif à une matrice de commutation photonique illustrée à la figure 4. A la première ligne de ce chronogramme sont représentées deux cellules, repérées CELL i et CELL i+1, séparées par des temps de garde, et comportant chacune un en-tête (zone grisée) et un champ de données utiles (zone hachurée). Les deux cellules ainsi représentées sont celles se présentant à l'entrée du dispositif de la figure 4, c'est-à-dire en entrée du coupleur 31. La ligne suivante représente ces mêmes cellules, appliquées à l'entrée de signal optique du convertisseur, avec un retard optique fixé par la ligne à retard 34 et correspondant essentiellement au temps de traitement par l'organe de commande 30, ce traitement comportant des opérations de réception (extraction des données spécifiques des cellules reçues), de routage (calcul d'itinéraire à partir de ces données spécifiques) et de marquage (application des informations de commande C au convertisseur de longueur d'onde).

Les deux lignes suivantes du chronogramme représentent respectivement les signaux de commande, notés Q1 et Q2, appliqués respectivement aux interrupteurs $l_1$ et $l_2$ de la figure 5.

Les deux lignes suivantes du chronogramme représentent respectivement les signaux d'horloge, par exemple $H_{21}$ et $H_{22}$, appliqués aux registres-tampons des deux chaînes de commande relatives à la commande de longueur d'onde.

La dernière ligne de ce chronogramme représente la succession des longueurs d'onde appliquées à l'électrode de commande de longueur d'onde du convertisseur : en l'occurrence la longueur d'onde notée "x" pour la cellule CELL i-1, la longueur d'onde notée "y" pour la cellule CELL i, et la longueur d'onde notée "z" pour la cellule CELL i+1.

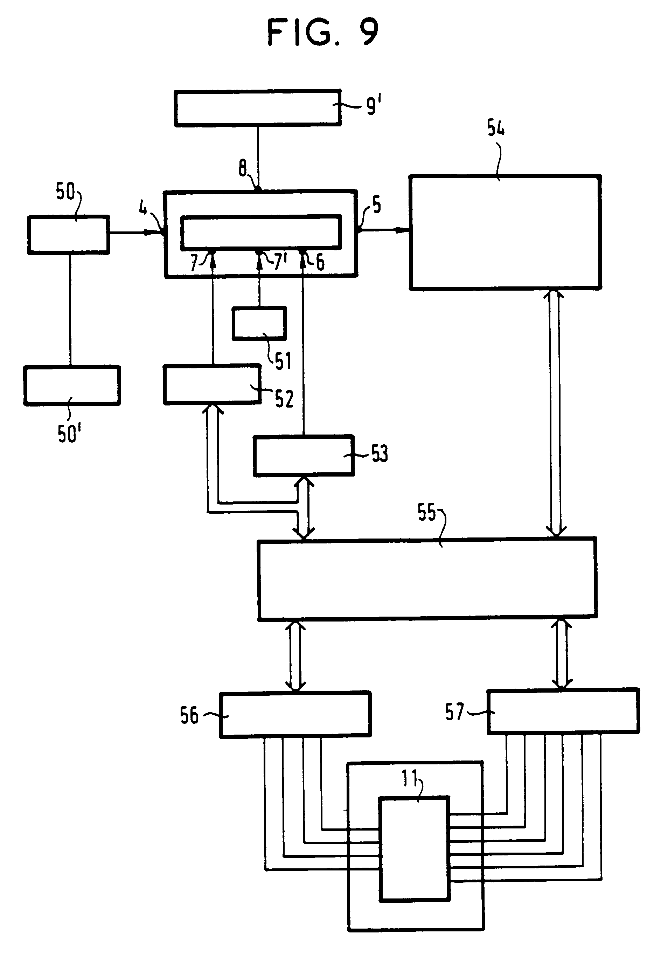

On décrit maintenant en relation avec la figure 9 un montage pour la mise en oeuvre de la phase dite d'étalonnage du procédé de commande suivant l'invention.

Aucune loi mathématique simple et généralisable ne liant la valeur de la longueur d'onde émise par un laser semi-conducteur accordable (donc à fortiori un convertisseur de longueur d'onde) à la valeur du ou des courants ou tensions électriques appliqués à ce composant, il convient en effet d'effectuer un relevé (ou cartographie) des caractéristiques d'émission du composant en fonction de ses caractéristiques de commande.

De ce relevé sera extrait un jeu de valeurs précises des courants de commande, permettant de fixer l'émission laser à un jeu de longueurs d'onde prédéterminé, et cela pour une température de fonctionnement nominale.

Le convertisseur de longueur d'onde est, pour ce relevé, placé en régime de fonctionnement continu, par un signal optique incident délivré par une source optique dite de commande 50 (alimentée par une source de signal électrique 50'), et caractérisé par un flux lumineux continu de puissance voisine de la puissance nominale Po de fonctionnement du composant en régime de déclenchement optique.

L'électrode 7' de commande d'absorbant saturable de ce convertisseur reçoit un courant de commande fixe $l_{20}$ correspondant également à un courant nominal de fonctionnement du composant en régime de déclenchement optique, et délivré par une source de courant 51.

Le courant $l_{20}$ de commande d'absorbant saturable détermine avec le courant $l_1$ de commande de gain, appliqué à l'électrode de commande de gain 7, les points de fonctionnement pour lesquels le laser est déclenchable optiquement au moyen de la puissance $P_0$.

L'ensemble de ces points de fonctionnement est en l'occurrence situé dans une région comprise entre une première et une deuxième courbe établies dans les conditions suivantes :

- pour la première courbe, avec :

  . $l_1$ évoluant dans le sens croissant,
  . $l_2$ fixe et égal à $l_{20}$,
  . puissance lumineuse incidente injectée dans le laser constante et égale à $P_0$,

- pour la deuxième courbe, avec

  . $l_1$ évoluant dans le sens décroissant,
  . $l_2$ fixe et égal à $l_{20}$,
  . puissance lumineuse incidente injectée dans le laser égale à zéro.

On notera que le courant $l_{20}$ est également celui alimentant l'électrode de commande d'absorbant saturable pendant la phase dite opératoire du procédé de commande suivant l'invention, et que la puissance lumineuse $P_0$ est également celle du signal lumineux incident pendant cette phase opératoire.

Pour effectuer le relevé de la longueur d'onde d'émission en fonction des caractéristiques de commande de ce laser, on effectue en l'occurrence un relevé de la longueur d'onde émise par le laser pour chaque valeur des courants $l_1$ de commande de gain et $l_3$ de commande de longueur d'onde, les valeurs de $l_1$ étant choisies dans la région correspondant aux points de fonctionnement du laser, définie comme indiqué plus haut.

Comme la longueur d'onde dépend essentiellement du courant de commande $l_3$, on obtient ainsi un ensemble de plages de valeurs séparées par des sauts plus abrupts lors des changements de valeurs du courant de commande $l_3$.

Pour l'établissement de ce relevé, le composant est par ailleurs régulé à sa température de fonctionnement nominale par un régulateur tel que 9', et il est en outre alimenté par des générateurs de signaux de commande de gain $l_1$ et de commande de longueur d'onde $l_3$, respectivement 52, 53 qui sont des générateurs étalonnés, de caractéristiques appropriées (résolution, précision et reproductibilité) pour une commande précise de l'accord en longueur d'onde.

Le signal émis par le composant est couplé à un dispositif 54 mesureur de longueur d'onde, de type interférométrique ou spectrophotométrique selon un état de l'art connu, capable de fournir avec une précision appropriée la valeur moyenne de la longueur d'onde d'émission.

L'enregistrement de la cartographie peut être effectué sous la commande d'un calculateur 55 qui collectera, sous forme échantillonnnée, les mesures effectuées par le mesureur de longueur d'onde.

La mémoire RAM 11 est alors programmée, en utilisant la valeur de longueur d'onde comme adresse (fournie par un générateur d'adresse 56 commandé par ce calculateur), par stockage d'un nombre binaire à "m" bits (fourni par un digitaliseur 57 commandé par le calculateur 55), représentant l'équivalent du courant (analogique) échantillonné sur "m" bits à appliquer aux m émetteurs du convertisseur numérique analogique alimentant le composant.

## Revendications

1.  Procédé de commande d'un convertisseur de longueur d'onde optique (2), en fonction de la longueur d'onde d'émission souhaitée, ledit convertisseur de longueur d'onde présentant une entrée (4) de signal optique pour la réception d'un signal optique dont la longueur d'onde est à convertir, une sortie (5) de signal optique, pour l'émission d'un signal optique dont la longueur d'onde est la longueur d'onde souhaitée, après conversion, et au moins une électrode de commande pour l'application d'au moins un signal électrique en vue de la commande de longueur d'onde du signal optique d'émission, caractérisé en ce qu'il comporte :

    - une phase dite d'étalonnage comportant elle-même

        . l'établissement d'une loi liant l'un au moins desdits signaux électriques de commande à ladite longueur d'onde d'émission souhaitée,
        . la mémorisation de ladite loi dans des moyens de mémorisation,

    - une phase dite opératoire comportant elle-même :

        . un adressage desdits moyens de mémorisation par des informations de commande (C) représentant la longueur d'onde d'émission souhaitée,
        . une conversion numérique-analogique des données issues des moyens de mémorisation ainsi adressés, pour application à ladite électrode de commande, ou auxdites électrodes de commande.

2.  Procédé selon la revendication 1, caractérisé en ce que ladite électrode de commande est l'électrode (6) de commande de longueur d'onde d'un laser semi-conducteur à absorbant saturable.

3.  Procédé selon la revendication 1, caractérisé en ce que lesdites électrodes de commande sont l'électrode (6) de commande de longueur d'onde et l'électrode (7) de commande de gain d'un laser semi-conducteur à absorbant saturable.

4.  Dispositif de mise en oeuvre du procédé selon l'une des revendications 1 à 3, caractérisé en ce qu'il comporte :

    - des moyens (11) de mémorisation de la loi liant l'un au moins desdits signaux électriques de commande à ladite longueur d'onde d'émission souhaitée,

    - des moyens (30) d'adressage de ces moyens de mémorisation par des informations de commande (C) représentant la longueur d'onde d'émission souhaitée,

    - des moyens (12) de conversion numérique-analogique des données issues des moyens de mémorisation ainsi adressés, pour application à ladite électrode de commande, ou auxdites électrodes de commande.

5.  Dispositif selon la revendication 4, caractérisé en ce qu'il comporte deux moyens de conversion numérique-analogique (121, 122), convertissant alternativement les données issues des moyens de mémorisation ainsi adressés, au rythme imposé pour les conversions de longueur d'onde sur le signal optique incident, et un commutateur (21) sélectionnant alternativement les données issues de l'un ou l'autre de ces moyens de conversion numérique-analogique.

## Patentansprüche

1.  Steuerverfahren für einen optischen Wellenlängenwandler (2) abhängig von der gewünschten Sendewellenlänge, wobei der Wellenlängenwandler einen optischen Signaleingang (4) für den Empfang eines optischen Signals, dessen Wellenlänge umgewandelt werden soll, einen optischen Signalausgang (5) für die Aussendung eines optischen Signals mit der nach der Umwandlung gewünschten Wellenlänge und mindestens eine Steuerelektrode zum Anlegen mindestens eines elektrischen Signals aufweist, um die Wellenlänge des optischen Sendesignals zu steuern, dadurch gekennzeichnet, daß es folgende Verfahrensschritte aufweist:

    - eine Eichphase, die ihrerseits enthält:

        . die Erstellung eines mindestens eines der elektrischen Steuersignale mit der gewünschten Sendewellenlänge verknüpfenden Gesetzes,
        . die Speicherung dieses Gesetzes in den Speichermitteln,

    - eine operative Phase, die ihrerseits enthält:

        . eine Adressierung der Speichermittel durch Steuerinformationen (C), die die gewünschte Sendewellenlänge repräsentieren,
        . eine Digital-Analog-Umwandlung der von den so adressierten Speichermitteln kommenden Daten, um das Analogsignal an die Steuerelektrode oder -elektroden anzulegen.

**2.** Verfahren nach Anspruch 1, dadurch gekennzeichnet, daß es sich bei der Steuerelektrode (6) um die Elektrode zur Steuerung der Wellenlänge in einem Halbleiterlaser mit absorbierender und sättigungsfähiger Sektion handelt.

**3.** Verfahren nach Anspruch 1, dadurch gekennzeichnet, daß es sich bei den Elektroden um die Steuerelektrode (6) für die Wellenlängensteuerung und die Steuerelektrode (7) für die Verstärkungssteuerung eines Halbleiterlasers mit absorbierender und sättigungsfähiger Sektion handelt.

**4.** Vorrichtung zur Durchführung des Verfahrens nach einem der Ansprüche 1 bis 3, dadurch gekennzeichnet, daß sie aufweist:

- Mittel (11) zur Speicherung des Gesetzes, das mindestens eines der elektrischen Steuersignale mit der gewünschten Sendewellenlänge verknüpft,
- Mittel (30) zur Adressierung dieser Speichermittel durch Steuerinformationen (C), die die gewünschte Sendewellenlänge repräsentieren,
- Mittel (12) zur Digital-Analog-Umwandlung der aus den so adressierten Speichermitteln kommenden Daten, um die umgewandelten Signale an die Steuerelektrode oder die Steuerelektroden anzulegen.

**5.** Vorrichtung nach Anspruch 4, dadurch gekennzeichnet, daß sie zwei Digital-Analog-Wandlermittel (121, 122), die abwechselnd die von den so adressierten Speichermitteln kommenden Daten in dem durch die Umwandlung der Wellenlänge des ankommenden optischen Signals vorgegebenen Rhythmus umwandeln, sowie einen Umschalter (21) aufweist, der abwechselnd die von dem einen oder dem anderen dieser Digital-Analog-Wandlermittel gelieferten Daten auswählt.

**Claims**

**1.** Method of controlling an optical wavelength converter (2) according to the required output wavelength, said wavelength converter having an optical signal input (4) adapted to receive an optical signal whose wavelength is to be converted, an optical signal output (5) adapted to emit an optical signal whose wavelength is the required wavelength, after conversion, and at least one control electrode for applying at least one electrical signal to control the wavelength of the output optical signal, characterised in that it comprises:

- a calibration phase comprising:

  . establishing a law linking at least one of said control electrical signals to said required output wavelength,
  . storing said law in storage means,

- an operative phase comprising:

  . addressing said storage means using control data (C) representing the required output wavelength,
  . digital-analogue conversion of the data from the storage means addressed in this way for application to said control electrode (s).

**2.** Method according to claim 1 characterised in that said control electrode is the wavelength control electrode (6) of a semiconductor laser incorporating a saturable absorber.

**3.** Method according to claim 1 characterised in that said control electrodes are the wavelength control electrode (6) and the gain control electrode (7) of a semiconductor laser incorporating a saturable absorber.

**4.** Device for implementing the method as claimed in any one of claims 1 to 3 characterised in that it comprises:

- means (11) for storing the law relating at least one of said electrical control signals to said required output wavelength,
- means (30) for addressing said storage means using control data (C) representing the required output wavelength,
- digital-analogue converter means (12) for data obtained from the storage means addressed in this way for application to said control electrode (s).

**5.** Device according to claim 4 characterised in that it comprises two digital-analogue conversion means (121, 122) alternately converting data from the storage means addressed in this way at the timing rate imposed for wavelength conversion on the input optical signal and a switch (21) selecting alternately data from one or the other of said digital-analogue conversion means.

# FIG. 1

# FIG. 2

# FIG. 3

EP 0 529 580 B1

FIG. 4

# FIG. 5

EP 0 529 580 B1

FIG. 6

EP 0 529 580 B1

EP 0 529 580 B1

# FIG. 7

# FIG. 8

CELL i

CELL i+1

CELL i

CELL i+1

Q1

Q2

H22

H21

X/CELL i-1     Y/CELL i     Z/CELL i+1

EP 0 529 580 B1

# FIG. 9